# EUROPÄISCHE PATENTANMELDUNG

(11) **EP 2 316 791 A1**
(43) Veröffentlichungstag der Anmeldung: **04.05.2011**
(21) Anmeldenummer: 10007983.9
(22) Anmeldetag: 30.07.2010
(51) Int. Cl.: C01B 31/02

(54) **Kohlenstoff-Nanopartikel, die kovalent über ein Verbrückungsmolekül an ein Zielmolekül gebunden sind, und ein Verfahren zu deren Herstellung**

(30) Priorität: 28.10.2009 DE 102009051126
(71) Anmelder: Karlsruher Institut für Technologie, 76131 Karlsruhe (DE)
(72) Erfinder: Balaban, Teodor Silviu, Prof. Dr., 76187 Karlsruhe (DE); Potratz, Stefanie, 75180 Pforzheim (DE); Hennrich, Frank, Dr., 76133 Karlsruhe (DE); Fischer, Regine, 76135 Karlsruhe (DE); Balaban, Mihaela Carmen, 76187 Karlsruhe (DE); Kappes, Manfred, Prof. Dr.,, 76275 Ettlingen (DE)

(57) **Zusammenfassung**

Die vorliegende Erfindung betrifft ein leicht zugängliches und vielseitig verwendbares Verfahren zur Herstellung modifizierter Kohlenstoff-Nanopartikel, insbesondere Kohlenstoff-Nanoröhren, die unter milden Bedingungen über Spacer (Verbrückungsmoleküle) **(2,3)** kovalent an Zielmoleküle **(4,5)** angebunden werden.

Weiterhin werden Kohlenstoff-Nanopartikel beansprucht, welche über Verbrückungsmoleküle **(2,3)** an Zielmoleküle **(4,5)** gebunden sind. Verbrückungsmoleküle **(2,3)** verbessern die Löslichkeit und die Dispergierbarkeit in Zubereitungen. Außerdem haben Verbrückungsmoleküle **(2,3)** die Funktion der elektronischen und räumlichen Trennung der Zielmoleküle **(4,5)** (Werkstoffes) von den Kohlenstoff-Nanopartikeln, insbesondere Kohlenstoff-Nanoröhren.

Ebenso zeigt die Erfindung Verwendungsmöglichkeiten auf für Kohlenstoff-Nanopartikel, welche über Verbrückungsmoleküle **(2,3)** an Zielmoleküle **(4,5)** gebunden sind. Hierbei sind die besonderen Eigenschaften der Kohlenstoff-Nanopartikel, insbesondere Kohlenstoff-Nanoröhren, in Kombination mit den Zielmolekülen **(4,5)** über Verbrückungsmoleküle **(2,3)** von zentraler Bedeutung.

## Beschreibung

Die vorliegende Erfindung betrifft modifizierte Kohlenstoff-Nanopartikel, insbesondere modifizierte Kohlenstoff-Nanoröhren, die über Verbrückungsmoleküle (Spacer) an Zielmoleküle (Werkstoffe) gebunden sind.

Kohlenstoff-Nanopartikel sind allgemein bekannt. Eine Form in der Kohlenstoff-Nanopartikel vorliegen können sind Kohlenstoff-Nanoröhren. Kohlenstoff-Nanoröhren haben sehr kleine zylindrische Strukturen mit einem Durchmesser von eins bis ein paar Nanometern und ein Längenverhältnis von 10 bis 1000. Kohlenstoff-Nanoröhren weisen eine Honigwaben-ähnliche hexagonale Struktur auf, worin jedes Kohlenstoffatom mit drei benachbarten Kohlenstoffatomen verbunden ist. Kohlenstoff-Nanoröhren können, in Abhängigkeit von ihrer genauen Struktur, als elektrischer Leiter oder als Halbleiter wirken. Kohlenstoff-Nanoröhren können z.B. als sog. single-walled carbon nanotubes (SWNT), also einwandige Kohlenstoff-Nanoröhren vorliegen. Im Folgenden werden diese Kohlenstoff-Nanoröhren der Einfachheit halber auch als SWNT bezeichnet. Diese SWNT sind aufgrund ihrer einzigartigen Eigenschaften Gegenstand intensiver Forschungsarbeiten. Zu den Eigenschaften der SWNT zählen dabei Stärke, Widerstandsfähigkeit, Steifheit, sehr hoher Elastizuitätsmodul, sowie thermische und elektrische Konduktivität.

SWNT bestehen im Wesentlichen aus sp²-hybridisierten Kohlenstoffatomen, die gem. B. I. Yakobsen und R. E. Smalley, American Scientist, Vol. 85, July-August, 1997, 324-337, typischerweise in Pentagonen oder Hexagonen angeordnet sind. Diese können, durch kontrolliertes und durch Metall-Nanopartikel katalysiertes Wachstum initiiert, in größeren Mengen und in reproduzierbarer Qualität dargestellt werden. Kohlenstoff-Nanoröhren können weiterhin auch in Form von sog. multiwall carbon nanotubes (MWNT), also mehrwandigen Kohlenstoff-Nanoröhren vorliegen. MWNT sind konzentrisch ineinander verschachtelte SWNT und weisen Eigenschaften auf, die denen der SWNT ähnlich, aber unterlegen sind. SWNT weisen im Gegensatz zu MWNT weniger Defekte auf und sind demgemäß stärker, widerstandsfähiger und haben eine höhere Leitfähigkeit.

Ob eine bestimmte Kohlenstoff-Nanoröhre metallisch leitend, halbleitend oder nichtleitend ist, wird unter anderem durch ihre Chiralität bestimmt. Ebenso ist die Unterteilung nach ihrem Durchmesser möglich, wobei SWNT Durchmesser von 0,7 bis 3 nm aufweisen und MWNT einen Durchmesser von 2 bis 20 nm aufweisen.

Um die Vorteile und die besonderen Eigenschaften von Kohlenstoff-Nanopartikeln nutzen zu können, bedarf es einer Anbindung an ein Zielmolekül oder einen Werkstoff. In der Literatur sind nur wenige Beispiele bekannt, bei denen Kohlenstoff-Nanoröhren kovalent an Werkstoffe angebunden wurden. Dies liegt in der Schwierigkeit begründet, Kohlenstoff-Nanoröhren chemisch zu modifizieren. Aufgrund der starken van-der-Waals Anziehungskräfte der Kohlenstoff-Nanoröhren untereinander und des hohen Längenverhältnisses liegen Kohlenstoff-Nanoröhren in Agglomeraten vor und sind somit unlöslich in den meisten Lösungsmitteln. Aufgrund der Neigung in Agglomeraten vorzuliegen, ist eine homogene Dispergierung von Kohlenstoff-Nanoröhren erschwert. Die Vereinzelung und Dispergierbarkeit der Kohlenstoff-Nanoröhren ist daher ein wichtiger Punkt wenn sie in Gemischen mit anderen Materialien verarbeitet werden.

In der aktuellen Forschung wurden Kohlenstoff-Nanoröhren in polymeren Kompositen (z. B. Epoxidharze) verarbeitet. Der Großteil der Strategien beschäftigen sich damit, die Dispergierbarkeit zu erhöhen, einschließlich Ultraschallbehandlungen, Intensivmischung mit Scherkraft, Zufügen von Tensiden, chemische Modifikation durch Funktionalisierung, Umhüllen der Kohlenstoff-Nanoröhren mit Polymeren und verschiedenen Kombinationen aus diesen. Es sind nur wenige Methoden bekannt, Kohlenstoff-Nanoröhren kovalent an das Epoxidharz zu binden.

Kohlenstoff-Nanopartikel werden auch in der pharmazeutischen Forschung als sogenanntes Transfektionsmittel untersucht. Aufgrund der Eigenschaft der Kohlenstoff-Nanoröhren Zellmembranen durchqueren zu können, sind sie von Interesse als Träger von biologisch aktiven Substanzen, wie beispielsweise Peptide, Nukleinsäuren und pharmakologische Wirkstoffe.

Die Anbindung von Kohlenstoff-Nanoröhren an Werkstoffe ist ein zeitaufwendiger, arbeitsreicher und kostenintensiver Prozess. Neutrale Kohlenstoff-Nanoröhren können nicht direkt an Werkstoffe angebunden werden. Chemische Modifikationen mit nützlichen funktionellen Gruppen sind notwendig.

In den Artikeln D. Tasis, N. Tagmatarchis, A. Bianco, M. Prato Chem. Rev. 2006, 106 (3), 1105-1136 und X. Peng, S. S. Wong Adv. Mater. 2009, 21, 625-642 werden Verfahren beschrieben, wonach Kohlenstoff-Nanoröhren mithilfe eines Gemisches aus rauchender Salpetersäure und konzentrierter Schwefelsäure oxidiert werden können. Diese oxidierten Kohlenstoff-Nanoröhren zeigen eine bessere Löslichkeit. Die Anwesenheit von organischen Säuregruppen bietet eine Vielzahl weiterer Modifikationsmöglichkeiten mit diversesten Materialien. Beispielsweise kann die Säure mit Thionylchlorid und Alkoholen bzw. Aminen zu Estern bzw. Amiden umgesetzt werden. Farbstoffe mit Alkoholgruppen wurden unter Veresterungsbedingungen an sog. SWNT-Säuren kovalent angebunden. Auch die direkte Veresterung bzw. Aminierung mit Alkoholen bzw. Aminen unter Katalyse von Diimiden ist beschrieben.

J. Zhu, J. Kim, H. Peng, J. L. Margrave, V. N. Khabashesku, E. V. Barrera Nanolett. 2003, 3(8), 1107-1113 und D. Tasis, N. Tagmatarchis, A. Bianco, M. Prato Chem. Rev. 2006, 106 (3), 1105-1136 beschreiben eine mehrstufige Synthese von kovalent funktionalisierten Kohlenstoff-Nanoröhren, welche die Anbindung von SWNT an Epoxidharze ermöglicht. Die Enden der SWNT wurden zunächst in einer Mischung aus Salpeter- und Schwefelsäure oxidiert. Nach Fluorierung der so gereinigten und modifizierten SWNT wurden diese durch nukleophile Substitution des Fluoratoms mit Aminen oder Diaminen erfolgreich kovalent funktionalisiert. Die derart funktionalisierten SWNT wurden mit Epoxidharz vermengt. Das Epoxid reagiert sowohl mit Aminen, als auch den Säuregruppen aus der Oxidation.

Der Artikel von Zhu et al. (J. Zhu, H. Peng, F. Rodriguez-Macias, J. L. Margrave, V. N. Khabashesku, A. M. Imam, K. Lozano, E. V. Barrera Adv. Funct. Mater. 2004, 14 (7), 643-648) beschreibt einen Syntheseweg, bei dem SWNT, die durch die Behandlung mit Säure gereinigt und an den Enden funktionalisiert wurden, einer radikalischen Addition unterzogen werden. Auf diese Weise konnten Alkyl-substituierte SWNT dargestellt werden. Verwendet man Bernsteinsäureanhydrid so werden die SWNT mit Ethylcarboxyl-Gruppen funktionalisiert. Die Acylgruppen wurden mithilfe von Thionylchlorid chloriert und anschließend mit Diaminen umgesetzt. Die so funktionalisierten SWNT wurden mit Epoxidharzen in einer Chloroformlösung vermengt und nach Entfernen des Lösungsmittels gehärtet.

In WO 2008104079 wird eine Methode beschrieben, um Kohlenstoff-Nanoröhren zu reduzieren und sie dadurch für nukleophile Substitutionen, z.B. mit Epoxidharzen, zugänglich zu machen. Auf diese Weise können Werkstoffe an Kohlenstoff-Nanoröhren direkt oder über einen sog. Spacer kovalent gebunden werden. Bi-funktionale Kohlenstoff-Nanoröhren wurden an Epoxidharze und andere Polymere, wie beispielsweise Polystyrol, gebunden.

Die WO 2008104078 beschreibt ein Verfahren, um das Epoxidharz auf radikalischem Wege in nur einem Schritt mit einem Spacer kovalent an Kohlenstoff-Nanoröhren anzubinden, indem sie mit Epoxidharz und einen Alken umgesetzt werden. Die Öffnung der Doppelbindung zu einem Radikal kann thermisch, kationisch oder photolytisch gestartet werden, so dass eine Reaktion mit der Kohlenstoff-Nanoröhre und dem Epoxid statt finden kann. Die Länge des Spacers wird durch die stöchiometrische Zusammensetzung von Alken und Epoxid-Harz eingestellt. Wenn das Epoxidharz mit einem Alken als Spacer mit Kohlenstoff-Nanoröhren in nur einem Reaktionsschritt umgesetzt wird, so ergibt sich eine Kettenlängenverteilung des Spacers, die Länge des Spacers kann somit nicht genau eingestellt werden kann.

Die direkte Umsetzung von Kohlenstoff-Nanoröhren mit Epoxidharzen ist aber unerwünscht, da auf diese Weise kein sog. Masterbatch (Grundmischung) zur Verfügung gestellt werden kann, welches im Folgenden mit unterschiedlichen Epoxidharzen angemischt werden kann. Unter dem Begriff Masterbatch versteht man Additivkonzentrate, die in Form von polymergebundenen Zusatzstoffen einer natürlichen Zubereitung oder einem Kunststoff (Rohpolymer) zum Einfärben oder zur Veränderung der Eigenschaften beimischt.

Die Modifikation von einwandigen Kohlenstoff-Nanohörnern, die den SWNT sehr ähnlich sind, mit Porphyrinen gelang in drei Syntheseschritten (c. Cioffi, S. Campidelli, C. Sooambar, M. Marcaccio, G. Marcolongo, M. Meneghetti, D. Paolucci, F. Paolucci, C. Ehli, G. M. A. Rahman, V. Sgobba, D. M. Guldi, M. Prato J. Am. Chem. Soc. 2007, 129, 3938-3945). Zunächst wurde ein einfach Boc-geschütztes (tert-Butylcarbamat) Diamin in einer nukleophilen Substitution mit dem Kohlenstoff-Nanohorn zur Reaktion gebracht. Das entschützte Amin wurde mit Acylchloriden umgesetzt. Die Prozedur nimmt ca. 10 Tage in Anspruch.

In Druckschrift DE 102005041378 A1 wird ein Verfahren zur Anbindung von Acylgruppen an Kohlenstoff-Nanopartikel über die Friedel-Crafts Acylierung beschrieben. Die hierbei zugrunde liegende Aufgabenstellung ist die Erhöhung der Löslichkeit oder der Dispergierbarkeit der Kohlenstoff-Nanopartikel, bzw. die Aufreinigung der Kohlenstoff-Nanopartikel zu optimieren. Eine kovalente Anbindung der Partikel über die Acylgruppe hinweg an einen Werkstoff wird nicht genannt.

Allgemein gesehen sind die bisherigen Methoden zur kovalenten Modifikation von Kohlenstoff-Nanopartikeln mit Werkstoffen sehr langwierig und beinhalten oft sehr viele Reaktionsschritte. Auch die Verwendung von teilweise teuren oder auch chemisch aggressiven Reagenzien machen diese Reaktionen unwirtschaftlich.

Ausgehend hiervon ist es die Aufgabe der Erfindung, ein leicht zugängliches und vielseitig verwendbares Verfahren zur Verfügung zu stellen, um modifizierte Kohlenstoff-Nanopartikel, insbesondere Kohlenstoff-Nanoröhren, unter milden Bedingungen über ein Verbrückungsmolekül (Spacer) kovalent an Werkstoffe anzubinden. Die kovalente Anbindung unmodifizierter Kohlenstoff-Nanopartikel an Werkstoffe soll in kurzer Zeit erfolgen und das Produkt soll leicht zu reinigen sein.

Eine weitere Aufgabe der Erfindung ist es, Kohlenstoff-Nanopartikel bereitzustellen, welche über Verbrückungsmoleküle an Zielmoleküle gebunden sind. Die Verbrückungsmoleküle sollen die Löslichkeit erhöhen bzw. die Dispergierbarkeit in Zubereitungen verbessern. Außerdem haben Verbrückungsmoleküle die Funktion der elektronischen und räumlichen Trennung des Zielmoleküls (Werkstoffes) von den Kohlenstoff-Nanopartikeln, insbesondere Kohlenstoff-Nanoröhren.

Ebenso ist es Aufgabe der Erfindung, Verwendungsmöglichkeiten für Kohlenstoff-Nanopartikel, welche über Verbrückungsmoleküle an Zielmoleküle gebunden sind, aufzuzeigen. Hierbei sind die besonderen Eigenschaften der Kohlenstoff-Nanopartikel, insbesondere Kohlenstoff-Nanoröhren, in Kombination mit den Zielmolekülen über Verbrückungsmoleküle von zentraler Bedeutung.

Die vorliegende Erfindung löst die Aufgabe durch das in Anspruch 1 beanspruchte Verfahren und die in Anspruch 7 beanspruchten Kohlenstoff-Nanopartikel. Bevorzugte Ausführungsformen sind in den rückbezogenen Ansprüchen beschrieben. Anspruch 12 bezieht sich auf die Verwendung der Kohlenstoff-Nanopartikel nach Anspruch 7.

Erfindungsgemäß wurde ein neues zweistufiges Syntheseverfahren gefunden, um Kohlenstoff-Nanopartikel über Verbrückungsmoleküle kovalent an Zielmoleküle anzubinden. Hierzu werden in einem ersten Schritt die Kohlenstoff-Nanopartikel unter den Friedel-Crafts-Bedingungen in Gegenwart einer Lewis-Säure zu einem acylierten Kohlenstoff-Nanopartikel umgesetzt. Bevorzugt werden Kohlenstoff-Nanoröhren eingesetzt.

Die Friedel-Crafts-Acylierung ist ein bekanntes Verfahren, das zur Herstellung aromatischer Ketone durch Reaktion aromatischer Verbindungen mit Acylierungsmitteln und Friedel-Crafts-Katalysatoren dient.

Friedel-Crafts-Katalysatoren sind sog. Lewis-Säuren, die bei der Acylierung äquimolar mit dem Acylierungsreagenz umgesetzt werden. Als Lewis-Säuren kommen AlCl₃, BF₃, FeCl₃ oder SnCl₄ in Frage. Bevorzugter Weise wird AlC1₃ als Lewis-Säure verwendet. Als Acylierungsmittel kommen in diesem Zusammenhang bevorzugter Weise Carbonsäurechloride und Carbonsäureanhydride in Frage. Da das Acylierungsmittel gleichzeitig das Verbrückungsmolekül ist, mit welchem der Kohlenstoff-Nanopartikel an ein Zielmolekül gebunden wird, ist es wichtig, dass das Verbrückungsmolekül in omega-Position eine Abgangsgruppe für die nukleophile Substitution, also ein Nukleofug, besitzt. Als Nukleofuge kommen bevorzugt Halogene zum Einsatz. Besonders bevorzugt wird Brom als Nukleofug verwendet.

Bei der Verwendung zyklischer Carbonsäureanhydride entsteht nach der hydrolytischen Aufarbeitung im Acylierungsschritt eine omega-ständige Carboxylgruppe. Die Hydroxylgruppe der omega-ständigen Carboxylgruppe kann direkt als Nukleofug verwendet werden. Als zyklische Carbonsäureanhydride werden Maleinsäureanhydrid, Glutarsäureanhydrid, Phthalsäureanhydrid oder Bernsteinsäureanhydrid sowie deren Derivate, d.h. mit Substituenten in der Alkylkette, eingesetzt. Besonders bevorzugt wird Glutarsäureanhydrid oder Bernsteinsäureanhydrid verwendet.

Im Folgeschritt wird das Nukleofug in omega-Position der acylierten Kohlenstoff-Nanopartikel in einer nucleophilen Substitution durch ein Nucleophil ersetzt, das am Zielmolekül bereits vorhanden ist. Nucleophile sind funktionelle Gruppen, die aufgrund ihrer negativen Ladung oder Partialladung bzw. ihrer Lewis-basischen Eigenschaften während einer Reaktion eine Gruppe mit entgegengesetzten Eigenschaften (Elektrophil) angreift. Im Zusammenhang mit der vorliegenden Erfindung können als Nucleophile Alkohole, Amine oder Sulfide verwendet werden.

Acylierte Kohlenstoff-Nanopartikel mit einer omega-ständigen Carboxylgruppe werden dementsprechend mit dem Zielmolekül zu Estern, Amiden oder Thioestern umgesetzt.

In einer bevorzugten Ausführung des Verfahrens werden die omega-acylierten Kohlenstoff-Nanopartikel in einer sog. Steglich-Kondensation bei Raumtemperatur umgesetzt. Für die Veresterung werden die omega-acylierten Kohlenstoff-Nanopartikel mit dem entsprechenden Alkohol z. B. unter Verwendung von EDC^{·}HCL (1-Ethyl-3-(3-dimethylaminopropyl)carbodiimid Hydrochlorid) und DMAP (*N,N*-Dimethylaminopyridin) als Katalysator in Dichlormethan umgesetzt. Die Amidierung wird beispielsweise mit EDC·HCl und HOBt·H₂O (1-Hydroxybenzotriazol) als Katalysator mit dem entsprechenden Amin in Dichlormethan realisiert.

Sofern das Nukleofug nicht an eine Carbonylgruppe in omega-Position zum acylierten Kohlenstoff-Nanopartikel gebunden ist, so sind die Reaktionsprodukte der nucleophilen Substitution Ether, Amine oder Thioether. Die omega-Nukleofug-substituierten Kohlenstoff-Nanopartikel werden bevorzugter Weise in Gegenwart einer Base umgesetzt. Als Basen können solche eingesetzt werden, die stark genug sind, die Alkohole, Amine oder Thiole zu deprotonieren. Besonders bevorzugt werden Kaliumcarbonat, Cäsiumcarbonat, Kaliumhydroxid, Kalium oder Natrium tert-Butanolat, Kalium oder Natrium eingesetzt. Insbesondere wird Natriumhydrid verwendet.

Im Zusammenhang mit dem erfindungsgemäßen Verfahren hat das Verbrückungsmolekül eine zentrale Aufgabe, da es eine Carbonylverbindung umfasst, welches zur Anbindung an die Kohlenstoff-Nanopartikel dient, und weiterhin eine Abgangsgruppe umfasst, welche durch eine funktionelle nukleophile Gruppe der Zielmoleküle ersetzt wird. Beispielsweise bei der Verwendung zyklischer Carbonsäureanhydride entsteht die Abgangsgruppe intrinsisch während des ersten Reaktionsschritts.

Durch die Möglichkeit, im ersten Reaktionsschritt gleichzeitig unterschiedliche Friedel-Crafts-Reagenzien zu verwenden, beispielsweise Säurechloride und Säureanhydride, können Kohlenstoff-Nanopartikel auch gemischt funktionalisiert werden. Die vorgegebenen stöchiometrischen Zusammensetzungen der Edukte bei der Friedel-Crafts-Acylierung sind hierbei ausschlaggebend für die Zusammensetzung der Reaktionsprodukte.

Die Erfindung umfasst weiterhin modifizierte Kohlenstoff-Nanopartikel, die kovalent über ein Verbrückungsmolekül an ein Zielmolekül gebunden sind. Das Verbrückungsmolekül ist über eine Carbonyl-Gruppe, bevorzugter Weise eine Ketongruppe, an den Kohlenstoff-Nanopartikel gebunden und das Zielmolekül ist über einen Ester, ein Amid, ein Thioester, ein Ether, ein Amin oder ein Thioether an das Verbrückungsmolekül gebunden.

Die Zielmoleküle, die im Schritt der nucleophilen Substitution an die Kohlenstoff-Nanopartikel gebunden werden, sind je nach Anwendungsgebiet flexibel wählbar.

Bevorzugt als Zielmoleküle sind Monomere, Oligomere oder (Co-) Polymere. Besonders bevorzugte sind in diesem Zusammenhang Epoxide, insbesondere Glycidol.

Weiterhin bevorzugt werden als Zielmoleküle Markermoleküle, insbesondere Fluoreszenzmarker für diagnostische Anwendungen, eingesetzt.

Ebenso ist es eine bevorzugte Ausführung, wenn das Zielmolekül ein pharmazeutischer Wirkstoff ist.

Bevorzugte Zielmoleküle sind auch Farbstoffe oder Pigmente, besonders bevorzugt sind Farbstoffe zum Einfangen von Lichtenergie (Lichtsammelpigmente) oder elektrisch leitfähige Pigmente.

Bevorzugte Zielmoleküle stellen elektrische Leiter oder Halbleiter dar.

Die chemische Beschaffenheit, sowie die Größe und Anzahl der Verbrückungsmoleküle, die an die Kohlenstoff-Nanopartikel gebunden sind, sind je nach Aufgabenstellung frei wählbar. Das Verbrückungsmolekül zwischen der Carbonylgruppe und dem Nukleofug kann eine Kohlenwasserstoffkette mit einer Länge von 2 bis 25 Kohlenstoffatome umfassen. Alternativ sind auch andere kettenförmige Molekülgruppen, wie Siloxane oder Polyethylenglykole mit einer Kettenlänge von 3 bis 25 Atomen verwendbar.

Wird beispielsweise zur Herstellung einer Zubereitung eine große räumliche Trennung zwischen den Nanopartikeln und dem Zielmolekül erwünscht, so kann ein entsprechend langkettiges Verbrückungsmolekül gewählt werden.

Im Rahmen der vorliegenden Erfindung bedeutet der Begriff Zubereitung ein Stoffgemisch aus mindestens zwei Stoffen, das Monomere, Oligomere und/oder (Co-)Polymere umfasst, wobei ein oder mehrere Lösungsmittel Teil der Zubereitung sein können. Beispiele für Zubereitungen sind Klebstoffe, Lacke, Harze oder Gemische aus (Co-)Polymeren.

Wird beispielsweise ein erfindungsgemäß modifiziertes Kohlenstoff-Nanopartikel, der kovalent über ein Verbrückungsmolekül an ein Zielmolekül gebunden ist als Transfektionsmittel für zellbiologische Zwecke verwendet, so ist das Verbrückungsmolekül mit einer kurzen Kohlenstoffkette zu wählen.

Durch geschickte Wahl der funktionellen Gruppen am Zielmolekül, können Kohlenstoff-Nanopartikel dem Milieu entsprechend löslich oder gut dispergierbar gemacht werden. Dies ist vorteilhaft bei der Aufreinigung der Produkte oder bei der Einmischung der erfindungsgemäßen modifizierten Kohlenstoff-Nanopartikel in Zubereitungen.

Die Erfindung umfasst weiterhin die Verwendung der erfindungsgemäßen modifizierten Kohlenstoff-Nanopartikel, die kovalent über ein Verbrückungsmolekül an ein Zielmolekül gebunden sind, für Zubereitungen, für die medizinische Diagnostik oder Therapie, sowie für die Fotovoltaik oder für elektrisch leitende oder halbleitende Bauteile. Bevorzugt werden Kohlenstoff-Nanoröhren eingesetzt.

Die erfindungsgemäßen modifizierten Kohlenstoff-Nanopartikel verleihen den Zubereitungen besondere mechanische und chemische Eigenschaften, wie elektrische und thermische Leitfähigkeit, Stärke bzw. Haltbarkeit. In den Materialwissenschaften, z.B. Klebetechnik, carbonverstärkte Bauteile, wird oft die Forderung nach einer sehr guten Dispergierung der Kohlenstoff-Nanopartikel in der jeweiligen Matrix gestellt. Man diskutiert hierfür, dass dies optimal durch die kovalente Anbindung der Kohlenstoff-Nanopartikel in die Matrix, z.B. Epoxid-Harz, erreicht werden kann. Besonders bevorzugt ist die Verwendung der erfindungsgemäßen Kohlenstoff-Nanopartikel in sog. Masterbatches.

Für die Verwendung der erfindungsgemäßen modifizierten Kohlenstoff-Nanopartikel zu pharmazeutischen Zwecken kommen ebenfalls die Eigenschaften von Kohlenstoff-Nanopartikeln zur Geltung. Zum einen können Kohlenstoff-Nanopartikel mit Wirkstoffen für Therapien kovalent verknüpft werden, welche dann am Wirkort, durch biochemische Reaktion oder als Katalysator für Bestrahlungstherapien optimal wirken können. Es wurde auch gezeigt, dass verschiedene Kohlenstoff-Nanopartikel als reaktionsneutrale Transfektionsmittel in der Zellbiologie verwendet werden können. Des Weiteren kann die kovalente Anbindung an Marker, insbesondere Fluoreszenzmarker, erfolgen, sodass diagnostische Untersuchungen ermöglicht werden.

Beispielsweise können Lichtsammelmoleküle, wie Porphyrine oder Phthalocyanine, wenn sie an elektrisch leitende erfindungsgemäße modifizierte Kohlenstoff-Nanopartikel gebunden sind, die umgewandelte Lichtenergie in Form von elektrischen Ladungen aufnehmen und weiterleiten. Aktuell werden in der Solartechnologie immer häufiger Kohlenstoff-Nanoröhren erprobt, die die etablierten, aber kostenintensiven Fullerene ersetzen sollen. Hier bietet die kovalente Anbindung von Farbstoffen, zur Lichtsammlung oder Ladungstrennung, eine praktikable Lösung für hocheffiziente Bauteile.

Auch bei der Verwendung der erfindungsgemäßen modifizierten Kohlenstoff-Nanopartikel in elektrischen Bauteilen können die besonderen elektrischen Eigenschaften entweder als Leiter oder als Halbleiter wichtige Funktionen haben. Dem Fachmann ist beispielsweise bekannt, dass Kohlenstoff-Nanoröhren in der Halbleitertechnologie als Dioden oder sog. Nanoschalter funktionieren, bzw. dass auch Kohlenstoff-Nanoröhren als Speichermedium Verwendung finden. Im Zusammenhang mit der vorliegenden Erfindung ist hier zu unterstreichen, dass es möglich ist, verschiedene Bauteile kovalent auf ökonomisch sinnvolle Weise zu verknüpfen, um beispielsweise die Möglichkeiten neuer Verbindungen zwischen Metall/Halbleiter und Kohlenstoff-Nanoröhren zu verwerten.

Die Erfindung wird im Folgenden mit Ausführungsbeispielen und folgenden Figuren erläutert.
**Fig. 1** Allgemeine Molekülstruktur einer Ausführung der erfindungsgemäßen Kohlenstoff-Nanoröhren.
**Fig. 2** Erfindungsgemäße Acylierung einer Kohlenstoff-Nanoröhre nach Verfahrensschritt 1.
**Fig. 3** Erfindungsgemäße nucleophile Substitution einer mit einem Verbrückungsmolekül acylierten Kohlenstoff-Nanoröhre nach Verfahrensschritt 2.

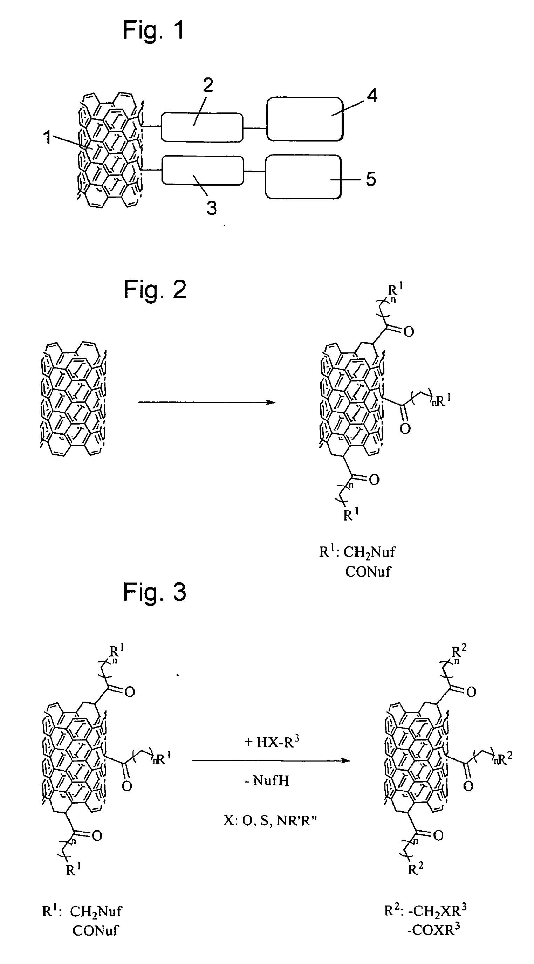

In der **Fig. 1** ist schematisch ein erfindungsgemäßer modifizierter Kohlenstoff-Nanopartikel dargestellt, wobei eine Kohlenstoff-Nanoröhre (SWNT) **1** über zwei unterschiedliche Verbrückungsmoleküle (Spacer) **2,3** an zwei unterschiedliche Zielmoleküle **4,5** kovalent angebunden ist. Die Anbindung der Verbrückungsmoleküle **2,3** an die Kohlenstoff-Nanoröhre **1** erfolgt in einem einzigen Reaktionsschritt, auch wenn unterschiedliche Verbrückungsmoleküle **2,3,** z.B. ein omega-substituierter Carbonsäurechlorid und ein zyklischer Carbonsäureanhydrid, verwendet werden. Bei einer solchen gemischten Derivatisierung ist auch die Anbindung unterschiedlicher Zielmoleküle **4,5,** wie in **Fig. 1** dargestellt, möglich. Somit können in dem erfindungsgemäßen Verfahren unterschiedliche Zielmoleküle **4,5** angebunden werden, die dem erfindungsgemäßen Kohlenstoff-Nanopartikel gleichzeitig unterschiedliche Eigenschaften verleihen, wie z.B. gute Dispergierbarkeit und Aufnahme von Lichtenergie.

Die Reaktionsfolge in **Fig. 2** zeigt schematisch den ersten Verfahrensschritt, womit die Verbrückungsmoleküle **2,3** unter Friedel-Crafts-Bedingungen an einen Kohlenstoff-Nanopartikel angebunden werden. Die in **Fig. 2** als "Nuf" gekennzeichnete Abgangsgruppe bezeichnet das Nukleofug, das im zweiten Verfahrensschritt gem. **Fig. 3** durch eine nukleophile funktionelle Gruppe am Zielmolekül **4,5** substituiert wird.

Die folgenden Beispiele 1-7 entsprechen dem prinzipiellen Reaktionsschema aus **Fig. 2**.

### Beispiel 1

In einem 250 mL Zweihalskolben mit magnetischem Rührer und Rückflusskühler, die über Nacht bei 110°C aufbewahrt wurden, wurde bei 120°C eine Mischung aus 5,4 g (40 mmol) Aluminiumchlorid und 2,4 g (40 mmol) Natriumchlorid unter Stickstoff eingefüllt. Die Mischung wurde bei 160°C zum Schmelzen gebracht. Dann wurden 100 mg Kohlenstoff-Nanoröhren (MWNT, Baytubes C150P) und portionsweise über 30 Minuten 4,0 g (40 mmol) Bernsteinsäureanhydrid zugefügt. Bei der Zugabe des Anhydrids konnte Rauchentwicklung beobachtet werden. Die Reaktionsmischung wurde für zwei Stunden bei 160°C gerührt und anschließend unter Stickstoff abgekühlt.

Zur Zersetzung (Hydrolyse) des Polyketon-Aluminiumchlorid-Komplexes wurde mit Eis und 2N Salzsäure versetzt und im Ultraschall behandelt. Die Suspension wurde für zwei Stunden bei 40°C gerührt und der Rückstand über einen Büchner-Trichter mit Saugflasche filtriert. Die acylierten Kohlenstoff-Nanoröhren wurden mit Wasser (500 mL) gewaschen. Das Produkt wurde in ein Zentrifugationsglas überführt und mit Aceton (3 mal 25 mL und 2 mal 10 mL) wiederholt aufgeschlämmt, zentrifugiert und dekantiert. Nach dem Trocknen an der Luft wurde eine Ausbeute von 330 mg acylierten Kohlenstoff-Nanoröhren in Form von schwarzem Pulver erhalten. Die Reinheit wurde mittel IR-Spektroskopie und REM untersucht.

### Beispiele 2-7

Beispiel 1 wurde wiederholt mit dem Unterschied, dass die in Tabelle 1 angegebenen Säurechloride bzw. -anhydride verwendet wurden. Die in Beispiel 3 angegebenen SWNT wurden durch gepulste Laserverdampfung mit Cobalt und Nickel als Katalysator hergestellt gem. der Anleitung aus S. Lebedkin, P. Schweiß, B. Renker, S. Malik, F. Hennrich, M. Neumaier, C. Stoermer, M. M. Kappes Carbon 2002, 40, 417-423.

**Tabelle 1: Ausführungen des in Beispiel 1 beschriebenen Syntheseschritts mit den in Spalte 2 angegebenen Säurechloride bzw. -anhydride. Die Ausbeuten der Reaktionen sind in Spalte 3 aufgelistet.**

| ***Beispiel*** | ***Säurechlorid bzw. - anhydrid*** | ***Ausbeute*** |
|---|---|---|
| 2 | Glutarsäureanhydrid (9,58 g, 84 mmol) | Aus 200 mg MWNT wurden 1,53 g Produkt erhalten |
| 3 | Glutarsäureanhydrid (2,4 g, 21 mmol) | aus 50 mg SWNT wurden 250 mg Produkt erhalten |
| 4 | Lauroylchlorid (40 mL, 0,17 mol) und Glutarsäureanhydrid (4,8 g, 42 mmol) | Aus 1 g MWNT wurden 1,26 g Produkt erhalten |
| 5 | 6-Bromhexanoylchlorid (7,65 mL, 50 mmol) | Aus 120 mg MWNT wurden 249 mg Produkt erhalten |
| 6 | 4-Brombutyrylchlorid (5,79 mL, 50 mmol) | Aus 120 mg MWNT wurden 197 mg Produkt erhalten |
| 7 | Hexanoylchlorid (48 mL, 0,34 mol) und 6-Bromhexanoylchlorid (12 mL, 80 mmol) | Aus 1 g MWNT wurden 1,38 g Produkt erhalten |

In der Reaktionsfolge in **Fig. 3** ist beispielhaft dargestellt, wie die Anknüpfung der Zielmoleküle **4,5** im zweiten Verfahrensschritt verlaufen kann. Die nukleofuge Abgangsgruppe (Nuf) in omega-Position eines Verbrückungsmoleküls **2,3** wird durch ein funktionelles Nukleophil, in **Fig. 3** als "X" gekennzeichnet, ersetzt. Das Nukleophil ist Teil eines Zielmoleküls **4,5.**

Die folgenden Beispiele 8-16 beziehen sich auf die Reaktionsfolge wie sie in **Fig. 3** dargestellt ist.

### Beispiel 8

In einem 100 mL Zweihalskolben mit magnetischem Rührer, welche über Nacht bei 110°C getrocknet wurden, wurden in 10 mL Dichlormethan (über CaH₂ getrocknet) 54 µl (0,81 mmol) (±)-Glycidol gelöst. Nach der Zugabe von 100 mg acylierten Kohlenstoff-Nanoröhren, wie unter Beispiel 2 dargestellt, wurden 0,22 g (1,15 mmol) EDC·HCl (1-Ethyl-3-(3-dimethylaminopropyl)carbodiimid Hydrochlorid) und 40 mg (0,32 mmol) DMAP (N,N-Dimethylpyridin) zugegeben. Nachdem die Suspension für 24 Stunden bei Raumtemperatur gerührt wurde, wurden Dichlormethan (50 mL) und Wasser (20 mL) zugefügt. Die Kohlenstoff-Nanoröhren wurden in einem Büchner-Trichter mit Saugflasche filtriert und mit Wasser (20 mL), gesättigter Natriumchlorid-Lösung (20 mL) und Wasser (100 mL) gewaschen. Nach dem Trocknen im Vakuum wurde das Produkt als schwarzes Pulver in 50 mg erhalten.

### Beispiel 9

Die Reaktion wurde analog zum Beispiel 8 durchgeführt in einem 25 mL Zweihalskolben mit 12,4 mg Kohlenstoff-Nanoröhren, wie unter Beispiel 2 dargestellt, 51,8 mg (0,08 mmol) 5-Hydroxymethyl-10,20-bisundecyl-21,23H-Porphyrin, 17,9 mg (0,09 mmol) EDC·HCl und 6 mg (0,05 mmol) DMAP in 3 mL getrocknetem Dichlormethan. Die Ausbeute beträgt ca. 2 mg des schwarzen Pulvers.

### Beispiel 10

In einem 25 mL Zweihalskolben mit magnetischem Rührer und Rückflusskühler wurden 100 mg acylierte Kohlenstoff-Nanoröhren, wie unter Beispiel 2 dargestellt, in 5 mL Methanol unter Stickstoff suspensiert und langsam mit konzentrierter Schwefelsäure (10 Tropfen, 95-97%) versetzt. Die Suspension wurde für zwei Stunden am Rückfluss erhitzt. Die abgekühlte Mischung wurde im Vakuum zur Trockene eingeengt und anschließend mit 25 mL Diethylether versetzt. Die Kohlenstoff-Nanoröhren wurden in einen Büchner-Trichter mit Saugflasche filtriert und mit je 10 mL Diethylether, gesättigter Natriumhydrogencarbonat-Lösung, Wasser und Diethylether gewaschen. Die Ausbeute beträgt 57 mg an modifizierten Kohlenstoff-Nanoröhren als schwarzes Pulver.

### Beispiel 11

Die Reaktion wurde wie unter Beispiel 8 beschrieben durchgeführt. In einem 25 mL Zweihalskolben wurden 25 mg Kohlenstoff-Nanoröhren, wie unter Beispiel 3 dargestellt, 22 mg (0,034 mmol) 5-Hydroxymethyl-10,20-bisundecyl-21,23H-Porphyrin, 36 mg (0,18 mmol) EDC·HCl und 12 mg (0,1 mmol) DMAP in 11 mL getrocknetem Dichlormethan miteinander umgesetzt. Die Ausbeute beträgt 11 mg des schwarzen Pulvers.

### Beispiel 12

Die Reaktion wurde analog der unter Beispiel 8 beschriebene durchgeführt. In einem 50 mL Zweihalskolben wurden unter Stickstoff 25 mg acylierte Kohlenstoff-Nanoröhren, wie unter Beispiel 3 dargestellt, 96 mg (0,19 mmol) (*E*)-4-(4-(Dimethylamino)styryl)-1-(2-hydroxyethyl)-2,6-diisopropylpyridinium Hexafluorophosphat, 550 mg (2,88 mmol) EDC·HCl, 94 mg (0,77 mmol) DMAP in 10 mL getrocknetem Dichlormethan umgesetzt. Die Ausbeute des schwarzen Pulvers beträgt 10 mg.

### Beispiel 13

In einem 25 mL Zweihalskolben mit magnetischem Rührer wurden in 10 mL Dichlormethan acylierte Kohlenstoff-Nanoröhren, wie unter Beispiel 3 dargestellt, unter Stickstoff suspendiert und mit 100 mg (0,75 mmol) HOBt·H₂O, 180 mg (0,95 mmol) EDC·HCl und 160 mg (0,95 mmol) Dodecylamin versetzt. Die Suspension wurde für 20 Stunden bei Raumtemperatur unter Stickstoff gerührt. Die Kohlenstoff-Nanoröhren wurden in einem Büchner-Trichter mit Saugflasche abfiltriert und mit Wasser (10 mL), 2N HCl (25 mL), gesättigter Natriumhydrogencarbonat-Lösung (25 mL), Wasser (50 mL) und Aceton (10 mL) gewaschen. Das getrocknete schwarze Pulver wurde mit einer Ausbeute von 30 mg erhalten.

### Beispiel 14

Die Reaktion wurde analog zu der unter Beispiel 13 beschrieben durchgeführt. In einem 25 mL Zweihalskolben mit magnetischem Rührer wurden unter Stickstoff 25 mg acylierte Kohlenstoff-Nanoröhren, wie unter Beispiel 3 dargestellt, 124,3 mg (0,25 mmol) (*E*)-1-(2-Aminoethyl)-4-(4-(dimethylamino)styryl)-2,6-diisopropylpyridinium Hexafluorophosphat, 45 mg (0,24 mmol) EDC·HCl und 25 mg (0,16 mmol) HOBt·H₂O in 10 mL Dichlormethan zur Reaktion gebracht. Das Produkt wurde in einer Ausbeute von 7 mg als schwarzes Pulver erhalten.

### Beispiel 15

In einem 25 mL Zweihalskolben mit magnetischem Rührer, die über Nacht bei 110°C getrocknet wurden, wurden in 2 mL THF (wasserfrei, frei von Stabilisator) 20 µL (0,3 mmol) (±)-Glycidol und portionsweise 14 mg (0,35 mmol) Natriumhydrid (60%ige Suspension in Paraffinöl) unter Stickstoff eingetragen. Die Suspension wurde eine Stunde bei Raumtemperatur gerührt bevor 50 mg der acylierten Kohlenstoff-Nanoröhren aus Beispiel 5 hinzugefügt wurden. Die schwarze Suspension wurde für weitere 23 Stunden bei Raumtemperatur unter Stickstoff gerührt. Es wurden 4 mL gesättigte Ammoniumchlorid- Lösung zugefügt und die Kohlenstoff-Nanoröhren abfiltriert. Das Produkt wurde mit Wasser (20 mL) und n-Hexan (10 mL) gewaschen. Das Produkt wurde in einer Ausbeute von 20 mg in Form eines schwarzen Pulvers erhalten.

### Beispiel 16

Die Reaktion wurde analog der unter Beispiel 15 beschriebenen durchgeführt. In einem 250 mL Zweihalskolben mit magnetischem Rührer, welche über Nacht bei 110°C getrocknet wurden, wurden 1,6 mL (19 mmol) (±)-Glycidol in 150 mL THF (absolut, ohne Stabilisator) unter Stickstoff portionsweise mit 300 mg (7,5 mmol) Natriumhydrid (60%ige Suspension in Paraffinöl) versetzt. Nach einer Stunde bei Raumtemperatur wurden 2,25 g acylierte Kohlenstoff-Nanoröhren, wie unter Beispiel 7 dargestellt, zugefügt und bei Raumtemperatur gerührt. Das Produkt wurde in 2,08 g als schwarzes Pulver erhalten.

### Bezugszeichenliste

- 1: Kohlenstoff-Nanoröhre
- 2: Verbrückungsmolekül 1
- 3: Verbrückungsmolekül 2
- 4: Zielmolekül 1
- 5: Zielmolekül 2

## Patentansprüche

1. Verfahren zur kovalenten Anbindung von Zielmolekülen an Kohlenstoff-Nanopartikel über mindestens ein Verbrückungsmolekül, umfassend folgende Verfahrensschritte:
a) Umsetzung von Kohlenstoff-Nanopartikeln mit einer Carbonylverbindung des mindestens einen Verbrückungsmoleküls in Gegenwart einer Lewis-Säure unter Friedel-Crafts-Bedingungen zu Acyl-Kohlenstoff-Nanopartikeln, die in omega-Position ein Nukleofug besitzen,
b) kovalente Anbindung eines Zielmoleküls an die omegasubstituierten Acyl-Kohlenstoff-Nanopartikel über nukleophile Substitution des Nukleofugs in omega-Position.

2. Verfahren nach Anspruch 1, wobei die Carbonylverbindung des mindestens einen Verbrückungsmoleküls ein Carbonsäurechlorid und/oder ein Carbonsäureanhydrid ist.

3. Verfahren nach einem der vorgenannten Ansprüche, wobei die Kohlenstoff-Nanopartikel Kohlenstoff-Nanoröhren sind.

4. Verfahren nach einem der vorgenannten Ansprüche, wobei das Nukleofug ein Halogen ist.

5. Verfahren nach einem der vorgenannten Ansprüche, wobei das Nukleofug eine Hydroxygruppe einer Carboxylgruppe ist.

6. Verfahren nach einem der vorgenannten Ansprüche, wobei das Zielmolekül als nukleophiler Substituent eine funktionelle Hydroxy-, Thiol- oder Aminogruppe besitzt, welche das Nukleofug während des Verfahrensschritts b) ersetzen.

7. Modifizierte Kohlenstoff-Nanopartikel, die kovalent über mindestens ein Verbrückungsmolekül an ein Zielmolekül gebunden sind, wobei das mindestens eine Verbrückungsmolekül über eine Carbonyl-Gruppe an das Kohlenstoff-Nanopartikel gebunden ist und weiterhin über eine Ester-, einen Thioester-, eine Amid-, eine Ether-, eine Thioether- oder eine Amingruppe an das Zielmolekül gebunden ist und eine Kohlenwasserstoff-, Polyethylenglykol- oder Siloxankette zwischen Kohlenstoff-Nanopartikel und Zielmolekül umfasst.

8. Modifizierte Kohlenstoff-Nanopartikel nach Anspruch 7, wobei mindestens zwei unterschiedliche Verbrückungsmoleküle an das Kohlenstoff-Nanopartikel gebunden sind.

9. Modifizierte Kohlenstoff-Nanopartikel nach Anspruch 7 oder 8, wobei das Zielmolekül ein Epoxid, ein optisch aktives Molekül, ein Polymer, ein pharmazeutischer Wirkstoff, ein elektrischer Leiter oder ein Halbleiter ist.

10. Modifizierte Kohlenstoff-Nanopartikel nach Anspruch 9, wobei das Zielmolekül Glycidol ist.

11. Modifizierte Kohlenstoff-Nanopartikel nach Anspruch 9, wobei das Zielmolekül ein Porphyrin oder ein Phthalocyanin ist.

12. Verwendung von modifizierten Kohlenstoff-Nanopartikeln, die gemäß einem der Ansprüche 7 bis 11 kovalent über ein Verbrückungsmolekül an ein Zielmolekül gebunden sind, für Klebstoffe, Zubereitungen oder Polymere, für die medizinische Diagnostik oder Therapie, oder für die Fotovoltaik.
